Europäisches Patentamt

European Patent Office

Office européen des brevets

(19)

(11) **EP 0 718 693 B1**

(12) **EUROPEAN PATENT SPECIFICATION**

(45) Date of publication and mention
of the grant of the patent:
**02.07.2003 Bulletin 2003/27**

(51) Int Cl.7: **G03F 7/004**, G03F 7/022

(21) Application number: **96102977.4**

(22) Date of filing: **22.12.1987**

(54) **Photoresist compositions and components**

Fotoresistzusammensetzungen und ihre Bestandteile

Compositions pour photoréserve et ingrédients

(84) Designated Contracting States:
**DE ES FR GB IT NL**

(30) Priority: **23.12.1986 US 2364**
**13.10.1987 US 108192**

(43) Date of publication of application:
**26.06.1996 Bulletin 1996/26**

(62) Document number(s) of the earlier application(s) in
accordance with Art. 76 EPC:
**87870199.4 / 0 273 026**

(73) Proprietor: **SHIPLEY COMPANY INC.**
**Marlborough, MA 01752 (US)**

(72) Inventors:
• **Daniels, Brian Kenneth**
**Chesterfield, Missouri 63017 (US)**
• **Madoux, David Charles**
**Maryland Heights, Missouri 63043 (US)**
• **Templeton, Michael Karpovich**
**Asherton, CA 94027 (US)**
• **Trefonas III, Peter**
**Medway, MA 02053 (US)**
• **Woodbrey, James Calvin**
**Chesterfield, Missouri 63017 (US)**
• **Zampani, Anthony**
**Westborough, MA 01581 (US)**

(74) Representative:
**Bunke, Holger, Dr.rer.nat. Dipl.-Chem. et al**
**Prinz & Partner GbR**
**Manzingerweg 7**
**81241 München (DE)**

(56) References cited:
EP-A- 0 211 667          US-A- 4 623 611
US-A- 4 719 167          US-A- 4 721 665

• **DATABASE WPI Section Ch, Week 8712 Derwent**
**Publications Ltd., London, GB; Class E21, AN**
**87-084322 XP002051278 & JP 62 036 663 A**
**(MITSUBISHI CHEM IND LTD) , 17 February 1987**

Remarks:
The file contains technical information submitted
after the application was filed and not included in this
specification

**Description**

BACKGROUND OF THE INVENTION:

1. Field of the invention:

This invention relates to photoresist compositions comprising a soluble resin, a photosensitizer and a solvent. Particularly, this invention relates to a photoresist process having advantages including high resolution capability.

2. Description of Prior Art

Various attempts have been made in the prior art to improve selected properties of photoresist compositions by using selected novolac resin formulations. For example, in U.S. Patents 4,377,631, 4,529,682 and 4,587,196, specific novolac resins made from mixtures containing meta- and para-cresols or ortho-, meta- and para-cresols were described as having utility in positive photoresist compositions with increased photospeed. In U.S. Patent 4,551,409, a naphthol containing resin and mixtures of the naphthol resin with another compatible resin are used in photoresist compositions to increase the heat distortion temperature of the photoresist. These prior-art compositions, while providing improved photospeed and improved thermal properties, do not provide particularly high contrast and resolution. This is a significant drawback in many industrial manufacturing processes for electronic circuit components that require fine-line resolution.

In Materials for Microlithography, L.F. Thompson, G.G. Wilson, and J.M. Frechet: Eds.; ACS Symposium Series 266, American Chemical Society, Washington, D.C., 1984, Chapter 17, p 339., a meta-cresol-benzaldehyde novolac resin was formulated with a photosensitizer and solvent to produce positive-toned images when the photoresist mixture was applied to a silicon wafer, exposed to actinic radiation and subsequently developed. However, the synthesis of the novolac resin, as taught, produces a material having low molecular weight, and photoresist compositions based on it have low photospeeds and resolution.

Also, it is well known in the art to produce positive photoresist formulations such as those described in U.S. Patents 3,666,473 and 4,409,314 and European Patent Application 0092444. These include alkali-soluble phenolic-formaldehyde novolac resins together with light-sensitive materials. Examples of the light sensitive materials are diazoquinones (DAQs) such as the sulfonate and carboxylate esters and the sulfon- and carbonamides obtained by reacting, respectively, oxo-diazonaphthalene sulfonyl and carbonyl halides with hydroxy, polyhydroxy, amino and polyamino ballast compounds (See U.S.Patent Application 174,556 filed on July 18, 1950 by Maximillian Paul Schmidt and now abandoned, and U.S. Patents 3,046,110, 3,046,122 and 3.046,123). The resins and sensitizers are dissolved in an organic casting solvent or mixture of casting solvents and are applied as a dried thin film or coating to a substrate suitable for the particular application desired.

The resin component of these photoresist formulations is soluble in aqueous alkaline solutions, but the admixed naphthoquinone sensitizer acts as a dissolution inhibitor with respect to the resin. Upon exposure of selected areas of a coated substrate to actinic radiation, the sensitizer undergoes a radiation induced chemical transformation, and the exposed areas of the coating are rendered more soluble than the unexposed area. This difference in solubility rates causes the exposed areas of the photoresist coating to be dissolved when the substrate is immersed in alkaline developing solution, while the unexposed areas are largely unaffected. This produces a positive relief resist pattern on the substrate. In most instances, the imagewise-exposed and developed resist pattern resulting on the substrate will be subjected to treatment by a substrate-etchant process. The photoresist pattern on the substrate protects the resist coated areas of the substrate from the etchant, and thus the etchant is only able to etch the remaining uncoated areas of the substrate which. in the case of a positive photoresist, correspond to the areas previously exposed to actinic radiation. Thus, an etched pattern can be created on the substrate which corresponds to the pattern of the mask, stencil, template, etc., that was used to create the latent images in the resist prior to development. The relief pattern of photoresist on the substrate produced by the method just described is useful for various applications, including the manufacture of miniaturized integrated electronic circuit components.

The term PAC as used in this present invention refers to the photoactive component of the resist composition. The PAC generally is sensitive to energetic forms of radiation such as ultraviolet (UV) light, undergoing radiation-induced chemcial transformations upon exposure to such radiation.

The properties of a photoresist composition which are important in commercial practice include the photospeed of the resist, development contrast and resist resolution capability and resist sidewall angle or wall profile, and resist adhesion. Increased photospeed is important for a photoresist, particu larly in applications where light of reduced intensity is employed such as in projection exposure techniques where the light is passed through a series of lenses and monochromatic filters. Development contrast is a measure of the photoresist's ability to faithfully transfer the mask dimensions through the entire thickness of the photoresist. Ideally the opening at the top of the photoresist film should have the same dimensions as at the bottom of the film. A resist with enhanced contrast generally has improved edge acuity and enhanced resolution capability.

Resist resolution refers to the capability of a resist system to reproduce with a given phototool the smallest multiple equal line/space features of a mask which is utilized during exposure with a high degree of image edge acuity in the developed spaces. In many industrial applications, particularly in the manufacture of miniaturized electronic components, a photoresist is required to provide a high degree of resolution for very narrow lines and spaces. The ability of a resist to reproduce very small dimensions, on the order of a micron or less, is extremely important in the production of very large scale integrated (VLSI) electronic circuits on silicon chips. Circuit density on such a chip can only be increased, assuming lithographic techniques are utilized, by increasing the resolution capabilities of the resist.

Various attempts have been made in the prior art to alter photoresist compositions in order to improve photoresist properties. For example, U.S. Patent 4,688,670 describes a triester-DAQ (tri-DAQ) PAC which achieves a moderate contrast. The composition described contains a PAC and a resin of different chemical structures than those of the present invention, resulting in inferior performance properties.

European Patent Application 85300184.0 describes several photoresist compositions containing polyester DAQ (poly-DAQ) PACs. Many of the PACs claimed in said patent application have only minimal solubility and aging stability in useful photoresist solvents. An overwhelming majority of the PACs in said patent application are esters of highly absorbant hydroxy-functional ballast molecules which have the property of a high absorbance and high non-bleachable absorbance. The absorbance properties of such compositions degrade resolution capabilities. Many of the PACs claimed In said patent application absorb in the visible spectrum, degrading mask alignment techniques. Also, an overwhelming majority of said photoresist compositions in said patent application have the property of poor yield of unexposed (or slightly exposed) film thickness remaining after development: i.e., in the range of 87-93 percent. The compositions taught in said patent application are different from those of the present invention with respect to PAC structure, PAC performance, resin composition and solvent composition. The photoresist compositions of the present invention have markedly better performance with respect to resolution capability, unexposed film thickness remaining after development, absorbance properties and visible transparency.

Japanese Patent 61/45420 A2 describes a photoresist composition containing a poly-DAQ PAC. The PAC, resin and solvent are different from those of the present invention. The performance properties of said composition, especially with respect to unexposed film thickness remaining after development, are inferior to that of this present invention.

Japanese Patent Application 8525660 (850213) describes a photoresist composition containing a PAC with a poly-DAQ PAC. The PAC, resin and solvent are quite different from those of the present invention.

Japanese Patent Application 84239330 (841115) describes a photoresist composition containing PACs, some of which contain a poly-DAQ PAC. The PAC, resin and solvent are of quite different composition from those of the present invention. In addition, the degree of PAC esteritication claimed is less than the range of the present invention.

U.S. Patent 4,555,469 describes a photoresist composition containing PACs, some of which may contain a poly-DAQ PAC. These PACs are esters of a novolac resin and are of a polymeric nature with structures different from those of the present invention. There are at most very minimal amounts of fully esterified PAC in the compositions of said patent, because the fully esterified novolac resin is minimally soluble in useful photoresist solvents. As shown in the present invention, the lack of fully esterified PACs lessens the resolution capability of photoresists based on such PACs. Also, the resin structure and solvent composition of said patent are different from those of the present invention.

The art of conventional positive photoresists is well known. For example, U.S. Patents 4,550,069 and 4,529,682 describe the principles of positive photoresist compositions, including differential solubility, contrast, photospeed, resolution, unexposed film thickness loss and applications. These and other patents describe typical embodiments, Including particular plasticising resins, dyes, anti-striation agents, adhesion promoters, and speed promoters.

With respect to the solvent component, an acceptable solvent must be capable of dissolving the required amounts of photosensitizer or PAC. Typically a photoresist formulation must contain between 2.5 and 5 percent by weight PAC in order to render the dried unexposed photoresist film sufficiently Insoluble in an aqueous alkaline developing solution. A widely used casting solvent composition for positive photoresists consists of a mixture of ethylene glycol monoethyl ether acetate, n-butyl acetate, and xylene in the ratio of 80:10:10, as taught in U.S. Patent 4,550,069.

The difficulty in dissolving PACs having multiple diazoquinone moieties with traditional solvents is a well known aspect of the prior art, as shown in European Patent 0,126,266 A2. Accordingly, in view of solubility limitations, it is common prior-art practice to use a mixture of sensitizers consisting of less soluble and more soluble types, or even to operate with the solution supersaturated relative to the less soluble sensitizer component. This practice can lead to precipitation of the sensitizer prior to or during use of the photoresist composition, and consequently can result in a short shelf life. There are several approaches to overcoming the solubility limitations. Among them are: (1) using a more soluble photosensltizer, (2) using a more effective solvent, and (3) using filtration of the composition immediately at the point of use. U.S. Patent 4,266,001 discloses certain organic esters of diazonaphthoquinone sulfonyl chloride (i.e. oxo-diazonaphthalene sulfonyl chloride) that are distinguished as having a high solubility in traditional photoresist solvents. Some of the prior-art photosensitizers consisting of certain esters of 1-oxo-2-diazonaphthalene-5-sulfonic acid are among the more soluble of PACs in traditional solvents, while many variations of these PACs, such as certain esters 1-oxo-2-diazonaphthalene-4-sulfonic acid are known to be less soluble, as discussed in B. Z. Yakovlev et al., Khim. Prom-st., 9, 564, 1981.

Traditional solvents used in the prior art include: ethyl cellosolve or ethylene glycol monoethyl ether, ethyl cellosolve acetate or ethylene glycol monoethyl ether acetate, methyl cellosolve or ethylene glycol monomethyl ether, methyl cellosolve acetate or ethylene glycol monomethyl ether acetate. N,N-dimethyl formamide, dioxane, and cyclohexanone, as shown in Japanese Patents 8286548 and 81202455. In order to improve coatability, up to 20 percent by weight of other solvents such as xylene, n-butyl acetate, and cyclohexane are included. Propylene glycol monoalkyl ethers are perceived by some people to be biologically safer solvents than the traditional ethylene glycol analogs (European Patent Application 85106774). Propylene glycol monoalkyl ether acetates are attributed to impart a photoresist photospeed advantage (U.S. Patent 4,550,069). Also, solvent combinations, such as solvents with 60 to 170°C boiling points admixed with solvents with 180 to 350°C boiling points, are claimed to eliminate coating striations as described in Japanese Patent Application J60024545-A.

Other solvents or mixtures of solvents have been discussed in the art as providing photoresist compositions of exceptional stability to storage. The active solvent in many of these formulations consists of pure, or in part, cyclopentanone and cyclohexanone as shown in Japanese Patent Application 84/155838. Combinations of cyclopentanone and cyclohexanone with 5- to 12-carbon aliphatic alcohols also are attributed to have good coating performance, as described in European Patent Application 0,126,266. Mixtures of acetone, ethylene glycol, and water are reported to form highly stable photoresist solutions, as shown in DE-A-2319159.

Nearly all of the solvents described above, as well as others in the prior art relating to photoresist compositions containing diazonaphthoquinonesulfonate or carboxylic acid esters of trihydroxybenzophenone, are limited in their applications. This is particularly the case when contemplated for industrial use where the combination of good solution stability, low toxicity, acceptable margin of safety against fires and explosions, and good coating characteristics is important. For example, methyl cellosolve acetate, N,N-dimethylformamide, and cyclohexanone have been implicated as biological threats to worker safety. In addition, structurally related alkylene glycol monoalkyl ethers and their acetates are potential biological threats to worker safety, as reported in the NIOSH Current Intelligence Bulletin 39, May 1983.

In order to provide an optimal margin of safety against fires and explosions, it is desirable for the photoresist composition to have as high a flash point as possible. This substantially restricts the use of highly volatile solvents such as acetone, cyclopentanone, and 1,4-dioxane, since these solvents have unacceptably low flash points. Since flash point generally correlates well with boiling point, the need for safety against fire and explosions places substantial restrictions on using solvents with boiling points below 110°C in photoresist compositions.

In addition to safety issues, the use of highly volatile solvents presents severe coating problems as well. Since efficiently practicing the art of high resolution microlithography requires maintaining critical dimension control from wafer edge to wafer edge, it is essential for a photoresist coating to have an extremely high degree of thickness uniformity, typically less than 50 angstroms variation across a 100 mm diameter substrate. Solvent mixtures containing as little as 5 percent of solvents with boiling points below 110°C tend to produce unacceptable thickness variation, because the drying time is likely to be too short compared to the spreading time in a typical spin coating process.

On the other hand, it is important for a photoresist solvent to be volatile enough to evaporate nearly completely during the coating process. This requirement places severe restrictions on the use of relatively high boiling solvents in photoresist compositions, especially since the post spin bake temperature cannot be raised much above 110°C without causing substantial thermal decomposition of the photosensitizer.

Finally, the distinction between physical solution stablility and chemical reactivity should be made. As discussed above, the literature has a number of examples of highly stable photoresists based on solvent mixtures containing cycloaliphatic ketones. Although these photoresists are highly stable in the sense that the photosensitizer does not precipitate out of solution, they are chemically unstable. The diazo moieties are reactive towards cycloaliphatic ketones. It is well known that the color of solutions of photosensitizer and cyclopenlanone, for example, turns from red to black on standing at room temperature for just a few days. Opening sealed sample vials of such solutions is accompanied by audiable release of pressurized nitrogen gas, indicating that the photosensitizer has undergone decomposition. The same is true of many amines, even to a higher degree. It is essential for industrially viable photoresist compositions to be free of such degradation effects.

EP-A-0,211,667, published as an intermediate document on 25.02.1987, discloses in its Example 1 a composition responsive to activating radiation to form a latent image developable with an aqueous alkali solution comprising at least one alkali-soluble resin and at least one photoactive compound that is a polyester derived from the reaction of an oxo-diazonaphthalene sulfonyl halide with a polyhydroxy ballast compound dissolved in a sole solvent, wherein said solvent is ethyl 2-oxypropionate. This composition is used for coating a solid support such as a silicon-based wafer and is said to have an excellent storage stability.

SUMMARY OF THE INVENTION

An object of this invention is to provide:

A photoresist composition having the advantages of high resolution capability.

Other objects, aspects and advantages of this invention will become apparent to those skilled in the art upon further study of this specification and appended claims.

The present invention provides an improved photoresist composition which can yield Increased contrast and resolution capability, plus yield improved unexposed film thickness remaining after development, reduced non-bleachable absorption in the near-UV actinic region, practical visible transparency and improved photoresist safety and stability. The compositions of the present invention utilize improved resins and PACs combined with specific solvents to provide requisite solvency power and safety characteristics.

DETAILED DESCRIPTION OF THE INVENTION:

The present invention provides a novel photoresist composition responsive to activating radiation to form a latent image developable with an aqueous alkali solution comprising at least one alkali-soluble resin and at least one photoactive compound that is an ester or polyester derived from the reaction of an oxo-diazonaphthalene sulfonyl or carboxylic acid halide with a hydroxy or polyhydroxy ballast compound dissolved in a solvent, wherein said solvent is ethyl lactate having a purity of greater than 99 percent.

Preferably, the solvent is present in an amount sufficient to dissolve said resin and said photoactive compound in order to form a single liquid phase.

Optionally, said solvent further contains at least one compound selected from the group consisting of: chlorobenzene, xylene, 4-hydroxy-4-methyl-2-pentanone, methoxy-2-propanol, 1-ethoxy-2-propanol, and 3-ethoxy-propanol.

Still prepferred, the composition of the present invention further comprises one or more additives selected from the group consisting of colorants, dyes, anti-striation agents, plasticizers, speed-enhancers, contrast-enhancers, and surfactants.

Besides, the present invention provides the use of a photoresist composition as claimed in any one of claims 1 to 4 for coating a solid support.

Preferably, said solid support is selected from the group consisting of semiconductor materials, metals, planarizing, barrier or etch-resistant types of organic or inorganic layers, underlying films and coatings, other types of resist films, antireflective coatings, plastic films, wood, paper, ceramics, glass, laminates and textiles. Even more preferred, said support is selected from the group consisting of a silicon-based or gallium arsenide-based wafer, aluminum and silicon dioxide. Advantageously, said photoresist composition is used in the manufacture of integrated electronic circuits and integrated circuit boards. The compositions of the present invention have the advantages of high contrast and resolution capability, high unexposed film thickness remaining after development, low percent non-bleachable absorption, minimal visible absorption and increased photoresist stability and safety.

The present Invention relates generally to photoresist compositions with PACs which are sensitive to energetic radiation. The energetic radiation typically consists of ultraviolet light, although other forms of radiolysis, including x-rays, gamma-rays, synchrotron radiation, electron beams and particle beams also may be used.

For many purposes, the photoresist compositions of the present invention are commonly used in a positive printing mode. Techniques for using the compositions of the present invention in the negative mode are also well known to those skilled in the art, examples of which are described by E. Ailing and C. Stauffer, Proc. SPIE, Vol. 539, pp 194-218 (1985) and F. Coopmans and B. Roland, Proc. SPIE, Vol. 631, pp 34-39 (1986).

Photoresist compositions of the present invention are also useful in a multilayer printing process. For example, these compositions can be used as an imaging layer coated on top of a planarizing layer, for example, as described by A.W. McCullough et al., Proc. SPIE, Vol. 631, pp 316-320(1986). These compositions can also be useful as a planarizing layer in a multilayer process, for example, as described by S.A. McDonald et al., Proc. SPIE. Vol. 631, pp 28-33 (1986).

The cresol novolac resins of the present invention are produced by condensing with formaldehyde a mixture of cresol isomers with the various cresol isomers present in proportions such that the cresol mixture consists essentially of less than 30 percent ortho-cresol, 25 to 46 percent meta-cresol and 24 to 75 percent para-cersol.

The most preferred cresol novolac resins of the present invention are produced by condensing formaldehyde with a mixture of cresol isomers, wherein the percentage values of the cresol isomers in the cresol mixture are given by the following two compositions: 1) less than 10 percent ortho-cresol, 40 to 46 percent meta-cresol and 44 to 60 percent para-cresol; and 2) 43 to 46 percent meta-cresol and 54 to 57 percent para-cresol.

These resins are prepared as described in Chapter 5 of Phenolic Resins, A. Knop and L.A. Pilato., Springer-Verlag. New York, 1985. After the resin is produced, it is characterized using solution viscosity measurements, differential scanning calorimetry, gel permeation chromatography and, in some examples, by combined gel permeation chromatography - low angle laser light scattering measurements as practiced in the art. The cresol-formaldehyde novolac resins useful in the present invention all have a glass transition temperature of 100 to 105°C and weight-average molecular weight of 4,000 to 35,000 Daltons.

Another useful class of phenolic resins of the present Invention is based on bishydroxymethylated phenolic compounds. A bishydroxymethylated phenolic compound such as 2,6-bis(hydroxymethyl)-p-cresol may be produced by reacting para-cresol with formaldehyde in the presence of a base. The bishydroxymethyl group of the compound is reactive and may in the presence of heat, acid or base react with Itself or with other reactive compounds. If the other reactive compound is a phenolic material, such as phenol, cresol, dimethylphenol, trimethylphenol, naphthol, biphenol, phenylphenol, bis(hydroxyphenyl)methane, isopropylidenebiphenol, catechol, resorcinol, thiobiphenol and the like, which contain at least two sites in the aromatic ring(s) of sufficient reactivity to undergo facile Friedel-Crafts reactions, then the condensation reaction of the said reactive compound with a bishydroxymethylated phenolic compound can sustain polymerization and result in the formation of polymers. If the reactants are of good purity, then high-molecular-weight polymers can be made. To prepare polymers having utility in photoresist compositions, the bishydroxymethylated phenolic compound and the reactive phenolic compound are dissolved in an appropriate non-reactive or non-interfering solvent and an acid catalyst is added. When a volatile reactive phenolic compound is used in excess, it may also serve as a solvent or co-solvent. The condensation reaction leading to polymer formation can be carried out below ambient, at ambient or above ambient temperature. It is generally more practical to conduct the reaction at elevated temperature. A suitable acid catalyst may be a mineral acid such as hydrochloric acid, sulfuric acid, phosphoric acid, or an organic acid such as oxalic acid. maleic acid, formic acid, toluenesulfonic acid and the like. In certain cases, inorganic catalysts may also be used. These may include compounds of Zn, Mn. Mg. Al, Ti, Cu, Ni and Co. Upon completion of the condensation reaction the solvent and unreacted reactive phenolic compound may be removed via volatilization under reduced pressure and elevated temperatures. Another method by which the polymer may be recovered from the reaction mixture is by precipitation of the polymer into a liquid which is a non-solvent for the polymer but a solvent for the reaction solvent, catalyst and unreacted reactants. If the precipitation approach is used, the polymer is dried at elevated temperatures under reduced pressure. The polymer produced in this manner has substantially an alternating copolymer structure.

The bishydroxymethylated phenolic compounds that are particularly useful in this invention are the reaction products of ortho-cresol, meta-cresol, para-cresol, 2-, 3- or 4-phenylphenol, 2,3-dimethylphenol, 3,4-dimethylphenol, 3,4,5-trimethylphenol, para-ethylphenol, para-propylphenol, para-butylphenol, para-nonylphenol, bromophenols, fluorophenols, chlorophenols, trimethylsilylphenol, chloromethylphenols, acylphenols, para-hydroxybenzoic acid, para-nitrophenol and the like with formaldehyde in the presence of base. A suitable base which will promote the reaction is sodium or potassium hydroxide.

The substantially alternating copolymer produced by the acid catalysed condensation reaction of a bishydroxymethylated phenolic compound and a reactive phenolic compound can be further reacted in the presence of acid with formaldehyde and the same or different reactive phenolic compound. The resin that results is substantially a block copolymer.

Another useful class of phenolic resins of the present invention is based on aromatic aldehydes. Aromatic aldehydes, compared to formaldehydes, are less reactive toward condensation reactions leading to polymerization. However, under more vigorous reaction conditions, aromatic aldehydes such as benzaldehyde, substituted benzaldehydes, naphthaldehyde and substituted naphthaldehydes can condense with a reactive phenolic compound such as meta-cresol in the presence of a strong acid catalyst such as sulfuric acid and toluenesulfonic acid to produce polymers. Generally the polymers that are produced, however, have low molecular weights, poor physical, mechanical and lithographic properties. We have discovered that, by using catalytic amounts of ionizable compounds of divalent sulfur such as sulfur dichloride, sodium thiosulfate, hydrogen sulfide, sodium sulfide, thiols, thiophenols, thioacetic acid, thioglycollic acid, mercapto alkyl sulfonic acid or hydroxyalkylthiols in conjunction with a strong acid catalyst, the condensation of aromatic aldehyde with a reactive phenolic compound results in the formation of polymers that have higher molecular weights and, therefore, are more suitable as resins for resists. The aromatic-aldehyde-based resins are very useful as resist resins since many of them provide resist formulations that have high photospeed and thermal stability. Furthermore, the properties of these resins may be further modified by including in the condensation a bishydroxymethylated phenolic compound.

Two or more resins of similar or different compositions can be blended or combined together to give additional control of lithographic properties of photoresist compositions. For example, blends of resins can be used to adjust photospeed and thermal properties and to control dissolution behavior in developer.

Higher resolution patterning capability is required as the density of circuits in electronic devices increases: e. g., as the industry progresses from VLSI to ultra large scale integration (ULSI) of circuit devices. Economical enhanced resolution patterning capability is offered by higher resolution photolithography. This generally requires higher resolution and higher contrast resist materials, which can tolerate a greater extent of degradation of the light aerial image caused by diffraction phenomena as feature size decreases. Increased resist contrast generally is a measure of increased resolution capabilities.

Positive photoresists containing DAQ sulfonic and carboxylic acid esters as the PAC(s) in a novolac polymer matrix are high resolution materials which do not swell during development and possess good dry-etch resistance. Typically, a suitable hydroxy-functional ballast compound, molecule or group is esterified with the DAQ group to give a base-insoluble ester PAC which greatly reduces the dissolution rate of the admixed base-soluble resin in an aqueous alkaline developer. Other substituent groups can be bonded to the ballast molecule to modify the solubility properties of the PAC. Acidic hydrophilic substituent groups such as acid and hydroxyl, or other hydrophilic groups such as polyethylene oxide groups, enhance the solubility of the PAC molecule in aqueous solutions. Hydrophobic substituent groups such as hydrocarbons, aryl halide, alkyl esters and aryl halide groups diminish the solubility of the PAC molecule in aqueous solutions. Upon photolysis in the presence of water, such as upon the irradiation of thin films under normal conditions, the DAQ groups undergo a sequence of reactions to ultimately form indene carboxylic acid (ICA) groups, which make the photolyzed PAC base-soluble. Thus, the irradiated regions of the photoresist film become soluble in the alkaline developer. The photochemistries of DAQ groups linked to the ballast molecule through carboxyl ester, sulphonate ester, carbonamide or sulfonamide linkages are essentially equivalent in terms of the photochemical and subsequent reactions which cause the PAC to become base-soluble. [Normal conditions are normal ambient temperature and humidity such as about 16 to 25°C (61 to 77°F) and about 25 to 75 percent relative humidity.] If two or more DAQ groups are bonded to the same ballast group, to form a multi-DAQ PAC, the DAQ groups undergo essentially independent sequential photolysis with increasing dose to ultimately form a multi-ICA product.

Contrast is primarily controlled by the rate of change of photoresist dissolution rate (and hence ultimately film thickness) with dose. A method for producing at least one element of a threshhold-like response into the initial phase of the photoresist development process, well known to those familiar with the art, is to introduce surface inhibition to development by adding various strong surfactants into the aqueous alkaline developer solutions.

The solvents of the present invention offer several new advantages, including: (1) better photosensitivity (2) lower toxicity, (3) an equivalent cast film thickness from lower percent solids formulations than with traditional solvents, and (4) better solvency and solution stability.

The importance of photosensitivity is well documented in the literature. Materials showing higher photosensitivities allow the photolithography process to have a higher throughput in terms of wafers exposed per hour. This translates into economic advantages of lower cost devices.

Without question, toxicity is an important issue in the workplace, especially since the traditional photoresist solvent, ethylene glycol monoethyl ether acetate, and related compounds such as ethylene glycol monomethyl ether acetate, have been found to be teratogenic (NIOSH Current Intelligence Bulletin 39, May 1983).

Photoresist compositions made with some of the solvents of this invention, have the property that, for a fixed percent solids, they give thicker films than compositions based on the traditional solvents. This effect translates into an economic advantage in that less of the expensive solid materials are required to produce a given coating thickness than with compositions made with traditional solvents.

The solvency power of a solvent or solvent mixture useful in positive photoresist compositions according to this invention can be exemplified in terms of solubility parameters, $\delta$. The development of the solubility parameter concept is related closely to developments in the theory of dissolution of organic compounds and polymers, or more specifically non-electrolytes. (See H. Burrell, 'Solubility Parameter Values," in Polymer Handbook, 2nd Edn., J. Brandup and I.H. Immergut, Eds., John Wiley, 1975.) The dissolution of a material is governed by the well known free energy equation:

$$\Delta G = \Delta H - T\Delta S$$

where $\Delta G$ is the Gibb's free energy change, $\Delta H$ is the heat of mixing, T is the absolute temperature, and $\Delta S$ is the entropy of mixing. A decrease in free energy, or negative $\Delta G$, implies that the dissolution will tend to occur spontaneously.

Since the dissolution process is always associated with a positive change in entropy, the magnitude of the $\Delta H$ is the deciding factor in determining the sign of the free energy change, Hildebrand and Scott proposed that

$$\Delta H_m = V_m \left[ \left( \frac{\Delta E_1}{V_1} \right)^{\frac{1}{2}} - \left( \frac{\Delta E_2}{V_2} \right)^{\frac{1}{2}} \right]^2 \Phi_1 \Phi_2$$

where $\Delta H_m$ is the overall heat of mixing; $V_m$ is the total volume of the mixture; $\Delta E$ is the energy of vaporization of the respective component 1 or 2; V is the molar volume of component 1 or 2; $\varphi$ is the volume fraction of the designated component 1 or 2 in the mixture. (See J. Hildebrand and R. Scott, The Solubility of Non-Electrolytes, 3rd Edn., Reinhold, N.Y., 1949.) The quantity ($\Delta E/V$) has been variously described as the "cohesive energy density." or $\delta^2$.

A number of workers, including C.M. Hansen, have extended the single component solubility parameter concept of Hildebrand by taking into account the various Intermolecular attractions that give rise to $\delta^2$. (See C.M. Hansen, The Three Dimensional Solubility Parameter and Solvent Diffusion Coefficient, Danish Technical Press, Copenhagen, 1967.) These attractions are mainly due to dispersion forces, dipolar forces, and hydrogen bonds. Thus $\delta^2$ can be written as:

$$\delta^2 = \delta_d^2 + \delta_p^2 + \delta_h^2.$$

The parameters themselves are computed by a number of methods, from equations of state, boiling points, densities, critical properties, etc. For purposes of this invention, it is appropriate to employ parameters determined after K.L Hoy. (See K.L Hoy, Tables of Solubility Parameters, Union Carbide Corporation Solvents and Coatings Materials Research and Development Department, Bound Brook, N.J., 1985.) The aggregate solubility parameter for a mixture, often referred to as simply the solubility parameter of the mixture, is the volume-fraction weighted-average of that solubility parameter for the components of the mixture.

In practice, these parameters are typically utilized in the form of a two dimensional plot of, for example, $\delta_p$ versus $\delta_h$. This surface contains a locus of points which define a characteristic region of solubility for a specific organic compound or polymer. Furthermore, any solvent or solvent mixture with solubility parameters $\delta_p$ and $\delta_h$ that fall within this region, will solubilize that particular organic compound or polymer. (See. for example. A.F.M. Barton, CRC Handbook of Solubility Parameters and Other Cohesion Parameters, CRC Press, Boca Raton, Florida, 1983.)

Typically the locus of points is empirically mapped out by conducting solubility tests of an organic compound with various solvents or solvent mixtures having known solubility parameters.

We have empirically determined a locus of points in solubility-parameter space corresponding to regions of solubility of various multi-DAQ PACs and mixed mono-, di-, and tri-DAQ PACs. These PACs have oxo-diazonaphthalene photoactive substituents bonded to various functional ballast groups through intervening linkages. The solvents and solvent mixtures utilized have broad ranges of solubility parameters or aggregate solubility parameters $\delta_d$, $\delta_p$ and $\delta_h$. For PACs based on similar types, relative amounts and dispositions of functional ballast groups and oxo-diazonaphthalene substituent groups, the solubilities of the PACs with carbonyl- and sulfonate ester and carbon- and sulfonamide intervening linkages are substantially the same. Instead of a cylindrical region of solubility-parameter space, as is typical of polymers, we have found that the region of solubility for the PACs corresponds more closely to the volume of solubility space defined by:

$$\delta_d > 4.4,$$

$$\delta_p > 3.6,$$

$$\delta_n > 3.0$$

and

$$\delta_p/\delta_h > 0.59,$$

where $\delta_d$, $\delta_p$, and $\delta_h$ are in units of $(cal/cm^3)^{0.5}$.

A solvent or mixture of solvents with solubility parameters in the above indicated region would not be wholly adequate as a practical photoresist solvent if it also possessed one or more of the following detrimental characteristics: 1) toxicity, 2) low margin of safety due to too low flash point, 3) poor coating characteristics, 4) insufficient volatility and dryability; and 5) reactivity towards PACs.

Therefore, in view of these factors, acceptable materials should:

i. have boiling point between 110° C and 180° C,

ii, consist of C, H and one or more of the elements: Cl, F, O,

iii. exclude cycloaliphatic ketones,

iv. exclude alkylene glycol monoalkyl ether acetates and related derivatives such as ethylene glycol monomethyl ether acetate.

Because the biological activity of solvents within the region of this invention generally increases with increasing solubility parameters, the solvents of this last class generally offer the combination of high solvency and lower biological activity.

From group constants, the dispersive, polar, and hydrogen bonding components of the solubility parameter of alkali-soluble phenolic resins are estimated to be 8.6, 5.7, and 3.7, respectively. (See K.L Hoy, Tables of Solubility Parameters, Union Carbide Corporation Solvents and Coatings Materials Research and Development Department, Bound Brook, N.J., 1985.) Since these solubility parameters are within the preferred region of PAC solvency, combinations of solvents with such resins, as in liquid photoresist compositions, generally will only change the overall solubility parameters towards improved solvency and solution stability.

The solvent useful in this invention is ethyl lactate distilled to a purity of greater than 39 percent, possibly further containing at least are of the compounds claimed in claim 3.

The following specific examples provide detailed illustrations of the methods of conducting the processes and producing and using the compositions of the present invention. These examples are not intended, however, to limit or restrict the scope of the invention in any way, and should not be construed as providing conditions, parameters or values which must be utilized exclusively in order to practice the present invention.

EXAMPLE 1

Novolac Resin from m-, p-, and o-Cresols

A 2-L four-neck resin kettle equipped with a stirrer, heating source, thermometer, variable reflux ratio distilling head and a nitrogen inlet tube was charged with 278.3g (99 percent pure) m-cresol, 335.5g (99 percent pure) p-cresol, 34,3g (99 percent pure) o-cresol, 68.3g of 36.9 percent formalin, 20 ml of deionized water and 12.0g of oxalic acid dihydrate. The mixture was heated to about 60° C at which point an exothermic condensation reaction ensued. When the reaction mixture temperature reached about 100°C, 273.3g of 36.9 percent formalin was added in about 30 minutes. The reaction was then allowed to continue for about 4 hours at reflux temperature. The more volatile components in the reaction mixture were removed by distillation at ambient pressure under a constant flow of nitrogen. When the temperature of the reaction mixture reached about 220°C, a partial vacuum pressure was applied and was gradually increased until a maximum vacuum of 7 mm Hg was achieved and the mixture was at about 228°C. The liquefied resin remaining in the kettle was poured into a tray under nitrogen and allowed to cool and solidify. About 516g of novolac resin having a glass transition temperature. Tg, of about 100°C was obtained.

EXAMPLE 2

An Oxo-diazonaphthalene-sulfonate Mixed Ester of 2,3,4-Trihydroxybenzophenone:

To a 25-L flask equipped with a constant temperature bath, thermometer, mechanical stirrer, and 2 1-L addition funnels were added 550g (2.50 moles) of 2,3,4-trihydroxybenzophenone, 750g (2.80 moles) of 1-oxo-2-diazonaphthalene-5-sulfonyl chloride and 11.350 L of reagent grade acetone. While the mixture was maintained at 20°C ± 0.3°C, 1425g (1.61 moles) of 12 percent sodium carbonate was added dropwise over 100 minutes. After the base addition, the reaction mixture was allowed to stir for 60 minutes at about 20°C. 250 ml of concentrated HCl was then slowly added to the mixture while keeping its temperature below 26° C. The reaction solution was filtered to remove the bulk of the NaCl, and the filtrate was added to 50 L of 1 percent HCl. The precipitated solid was stirred one hour, filtered and collected. The solid was slurried twice in 25 L of deionized water, filtered and vacuum dried to 0.1 mm Hg at ambient temperature. About 1100g (85 percent of the theory) of a yellow, free flowing product containing about 34 percent by weight triester was obtained. By changing the ratio of the 1-oxo-2-diazonaphthalene-5-sulfonyl chloride to 2,3,4-trihydroxybenzophenone, the percent by weight of triester in the PAC product, and thus the percent by weight of PAC molecules without acidic hydrophilic groups, can be adjusted as desired.

EXAMPLE 3

In order to show the superiority of certain solvent mixtures the performance of the following resist compositions were compared with one another:

| | |
|---|---|
| A. Resin of Example 1 | 21.00 g |
| PAC of Example 2 | 5.25 g |
| Ethyl lactate g | 51.79 |
| Anisole | 9.58 g |
| Amyl acetate | 9.58 g |
| B. Resin of Example 1 | 18.21 g |
| PAC of Example 2 | 4.55 g |
| Ethyl lactate | 51.79 g |
| Anisole | 9.58 g |
| Chlorobenzene | 9.58 g |
| C. Resin of Example 1 | 14.04 g |
| PAC of Example 2 | 3.51 g |
| Ethyl cellusolve acetate | 42.70 g |
| n-Butyl acetate | 4.74 g |
| D. Resin of Example 1 | 18.21 g |
| PAC of Example 2 | 4.55 g |
| Propylene clycol monomethyl ether acetate | 55.34 g |
| Anisole | 6.15 g |

| Results | | | | |
|---|---|---|---|---|
| Resist Compositions | A | B | C | D |
| Film thickness at 4,000 rpm | 15,510 Å | 17,989 Å | 12,153 Å | 14,249 Å |
| Photospeed[1], EE (mj/cm$^2$) | 53.2 | 48.5 | 62.7 | - |
| Photosensitivity[1], Eo (mj/cm$^2$) | 22.36 | 22.12 | 24.24 | - |
| Contrast[1] (gamma) | 2.5 | 2.43 | 2.11 | - |

[1]Determined at a constant film thickness of 12,100 Å +/-150 Å.

These results show that resist compositions A and B require lower percentage of solids to product a given film thickness of resist than the resist compositions C and D that are based on conventional solvents of prior art. The lower exposure dose required for resist compositions A and B allow higher wafer throughput per given time during the article manufacture and the higher contrast numbers of A and B are indicative of higher resolution capability.

EXAMPLE 4

The following example demonstrates the Importance of an essentially pure ethyl lactate in resist compositions according to this invention. Two resist compositions were prepared essentially as described in Example 3 A. In one resist composition commercially available ethyl lactate (containing about 97 percent ethyl lactate, about 3 percent other impurities, as determined by standard gas chromatography method) was used. The other resist composition was prepared using a freshly distilled ethyl lactate that was determined by gas chromatography to be greater than about 99% pure. Both resist samples were filtered through a 0.2μm filter before stored in a refrigerated environment for about four months. The samples were then spin coated onto clean silicon wafers and examined under monochromatic light The films spun from the resist sample containing the commercial ethyl lactate typically showed about 120 visible particles per wafer while the resist films spun from the purified ethyl lactate were of high quality with no particles present.

## Claims

1. A composition responsive to activating radiation to form a latent image developable with an aqueous alkali solution comprising at least one alkali-soluble resin and at least one photoactive compound that is an ester or polyester derived from the reaction of an oxo-diazonaphthalene sulfonyl or carboxylic acid halide with a hydroxy or polyhydroxy ballast compound dissolved in a solvent, wherein said solvent is ethyl lactate distilled to a purity of greater than 99 percent.

2. The composition of claim 1, wherein said solvent is present in an amount sufficient to dissolve said resin and said photoactive compound in order to form a single liquid phase.

3. The composition of claim 1 or claim 2, wherein said solvent further contains at least one compound selected from the group consisting of: chlorobenzene, xylene, 4-hydroxy-4-methyl-2-pentanone, methoxy-2-propanol, 1-ethoxy-2-propanol, and 3-ethoxy-propanol.

4. The composition of any one of claims 1 to 3, further comprising one or more additives selected from the group consisting of colorants, dyes, anti-striation agents, plasticizers, speed-enhancers, contrast-enhancers, and surfactants.

5. Use of a photoresist composition as claimed in any one of the preceding claims for coating a solid support.

6. The use of claim 5, wherein said solid support is selected from the group consisting of semiconductor materials, metals, planarizing, barrier or etch-resistant types of organic or inorganic layers, underlying films and coatings, other types of resist films, antireflective coatings, plastic films, wood, paper, ceramics, glass, laminates and textiles.

7. The use of claim 5 or 6, wherein said support is selected from the group consisting of a silicon-based or gallium arsenide-based wafer, aluminum and silicon dioxide.

8. Use of a photoresist composition as claimed in any one of claims 1 to 4 in the manufacture of integrated electronic circuits and integrated circuit boards.

## Patentansprüche

1. Gegenüber aktivierender Strahlung empfindliche Zusammensetzung zur Bildung eines mit einer wäßrig alkalischen Lösung entwickelbaren latenten Bildes, umfassend mindestens ein alkalilösliches Harz und mindestens eine lichtempfindliche Verbindung, die in einem Lösemittel gelöst sind, wobei die mindestens eine lichtempfindliche Verbindung ein aus der Umsetzung eines Oxodiazonaphthalin-sulfonylhalogenids oder Carbonsäurehalogenids mit einer Hydroxy- oder Polyhydroxy-Ballastverbindung abgeleiteter Ester oder Polyester ist und wobei das Lösemittel Ethyllactat ist, das auf eine Reinheit von mehr als 99% destilliert worden ist.

2. Zusammensetzung nach Anspruch 1, bei der das Lösemittel in einer zur Lösung des Harzes und der lichtempfindlichen Verbindung unter Bildung einer einzigen flüssigen Phase ausreichenden Menge vorhanden ist.

3. Zusammensetzung nach Anspruch 1 oder Anspruch 2, bei der das Lösemittel zusätzlich mindestens eine Verbindung enthält, die aus der aus Chlorbenzol, Xylol, 4-Hydroxy-4-methyl-2-pentanon, Methoxy-2-propanol, 1-Ethoxy-2-propanol und 3-Ethoxypropanol bestehenden Gruppe ausgewählt ist.

4. Zusammensetzung nach einem der Ansprüche 1 bis 3, die zusätzlich mindestens ein Additiv enthält, das aus der aus Färbemitteln, Farbstoffen, die Schlierenbildung verhindernden Mitteln, Weichmachern, Beschleunigern, Kontrastverstärkern und oberflächenaktiven Mitteln bestehenden Gruppe ausgewählt ist.

5. Verwendung einer Photoresistzusammensetzung gemäß einem der vorhergehenden Ansprüche zur Beschichtung eines festen Trägers.

6. Verwendung nach Anspruch 5, wobei der feste Träger ausgewählt wird aus der aus folgenden Materialien bestehenden Gruppe: Halbleitermaterialien, Metalle, planarisierende, als Sperrschicht wirkende oder ätzfeste organische oder anorganische Schichten, Grundier-Filme und -beschichtungen, andere Arten von Resistfilmen, reflexionshemmende Beschichtungen, Kunststoffolien, Holz, Papier, Keramik, Glas, Laminate und Textilstoffe.

7. Verwendung nach Anspruch 5 oder 6, wobei der Träger ausgewählt wird aus der aus Halbleiterscheiben auf Basis von Silizium oder Galliumarsenid, Aluminium und Siliziumdioxid bestehenden Gruppe.

8. Verwendung einer Photoresistzusammensetzung gemäß einem der Ansprüche 1 bis 4 bei der Herstellung von integrierten elektronischen Schaltungen und von Leiterplatten mit integrierten Schaltungen.


**Revendications**

1. Composition sensible à un rayonnement d'activation pour former une image latente pouvant être développée avec une solution alcaline aqueuse comprenant au moins une résine soluble dans les alcalis et au moins un composé photoactif qui est un ester ou un polyester provenant de la réaction d'un halogénure d'oxodiazonaphtalène sulfonyle ou d'acide carboxylique avec un composé ballast hydroxylé ou polyhydroxylé dissous dans un solvant, ledit solvant étant le lactate d'éthyle distillé à une pureté de plus de 99 pour cent.

2. Composition selon la revendication 1, dans laquelle ledit solvant est présent dans une quantité suffisante pour dissoudre ladite résine et ledit composé photoactif de façon à former une seule phase liquide.

3. Composition selon la revendication 1 ou la revendication 2, dans laquelle ledit solvant contient en outre au moins un composé choisi dans le groupe constitué par le chlorobenzène, le xylène, la 4-hydroxy-4-méthyl-2-pentanone, le méthoxy-2-propanol, le 1-éthoxy-2-propanol et le 3-éthoxy-propanol.

4. Composition selon l'une quelconque des revendications 1 à 3, comprenant en outre un ou plusieurs additifs choisis dans le groupe constitué par les colorants, les peintures, les agents anti-stries, les plastifiants, les agents augmentant la vitesse, les agents augmentant le contraste et les agents tensio-actifs.

5. Utilisation d'une composition de photoréserve telle que définie à l'une quelconque des revendications précédentes pour l'application en revêtement sur un support solide.

6. Utilisation selon la revendication 5, dans laquelle ledit support solide est choisi dans le groupe constitué par les matériaux semi-conducteurs, les métaux, les types à effet de planarisation, de barrière ou résistant à l'attaque de couches organiques ou minérales, films sous-jacents et revêtements, d'autres types de films de réserve, les revêtements antiréfléchissants, les films plastiques, le bois, le papier, la céramique, le verre, les stratifiés et les textiles.

7. Utilisation selon l'une des revendications 5 ou 6, dans laquelle ledit support est choisi dans le groupe constitué par les microplaquettes à base de silicium ou à base d'arséniure de gallium, l'aluminium et le dioxyde de silicium.

8. Utilisation d'une composition de photoréserve telle que définie à l'une quelconque des revendications 1 à 4, dans la fabrication de circuits électroniques intégrés et de plaquettes à circuits intégrés.